# FASCICULE DE BREVET EUROPEEN

(11) **EP 1 614 764 B1**
(45) Date de publication et mention de la délivrance du brevet: **08.04.2009**
(21) Numéro de dépôt: 04103220.2
(22) Date de dépôt: 07.07.2004
(51) Int. Cl.: C23C 14/06, G04B 37/22

(54) **Revêtement décoratif par déposition de couches alternées de nitrures**
Dekorative Beschichtung durch die Abscheidung von abwechselnden Nitridschichten
Decorative coating by deposition of alternating nitrure layers

(43) Date de publication de la demande: 11.01.2006
(73) Titulaire: Haute Ecole Arc NE-BE-JU, 2000 Neuchâtel (CH)
(72) Inventeur: Constantin, Raymond, 2013 Colombier (CH); Steinmann, Pierre-Albert, 2325 Les Planchettes (CH)
(74) Mandataire: P&TS Patents & Technology Surveys SA

(56) Documents cités:
- US-A- 4 591 418
- US-A- 4 699 850
- US-A- 4 791 017
- US-A1- 2002 172 843
- US-B1- 6 168 242
- PATENT ABSTRACTS OF JAPAN vol. 009, no. 228 (C-303), 13 septembre 1985 (1985-09-13) & JP 60 089565 A (SEIKO DENSHI KOGYO KK), 20 mai 1985 (1985-05-20)
- DATABASE COMPENDEX [Online] ENGINEERING INFORMATION, INC., NEW YORK, NY, US; 25 avril 1993 (1993-04-25), MUNZ W -D: "Production of PVD decorative hard coatings using multitarget UBM coating machines" XP002319943 Database accession no. EIX94011746543 -& PROC ANNU TECH CONF SOC VAC COATERS; PROCEEDINGS, ANNUAL TECHNICAL CONFERENCE - SOCIETY OF VACUUM COATERS 1993 PUBL BY SOC OF VACUUM COATERS, ALBUQUERQUE, NM, USA, 1993, pages 411-418, XP008043943
- PATENT ABSTRACTS OF JAPAN vol. 2003, no. 12, 5 décembre 2003 (2003-12-05) & JP 2004 269916 A (CITIZEN WATCH CO LTD), 30 septembre 2004 (2004-09-30)

## Description

### Domaine technique

La présente invention se rapporte au domaine des revêtements obtenus par déposition PVD, et notamment à un procédé de déposition de couches alternées de faible épaisseur pour obtenir une surface décorative dont la couleur avoisine celle de l'or.

### Etat de la technique

L'industrie horlogère ou du domaine décoratif de manière plus générale est confrontée au problème de produire des articles décoratifs présentant l'aspect et la couleur de l'or, ou d'autres métaux fins, tout en évitant les coûts liés par exemple à une production en or massif.

Il existe donc plusieurs procédés pour déposer des couches superficielles d'or sur un article en un matériau moins noble, comme par exemple laiton ou acier. Une limitation de ces procédés est que l'or est un matériau particulièrement mou, ce qui signifie qu'un dépôt d'or sur un article décoratif s'usera très rapidement, mettant rapidement à nu le substrat (acier inox, laiton nickelé ou autre...). Tous les horlogers ou bijoutiers sont confrontés à ce problème qui n'est résolu à présent que de manière contournée, c'est à dire par l'utilisation d'or massif, très cher, ou l'utilisation de placages galvaniques d'alliages d'or d'épaisseur 5 ou 10 µm afin d'obtenir une durée de vie acceptable, bien que limitée.

L'utilisation de fines couches d'or (flash) d'environ 0.1-0.2 µm, n'offre qu'une résistance à l'usure extrêmement limitée et elle est réservée à des articles qui ne sont pas destinés à être touchés, par exemple dans les cadrans de montre, ou à des imitations sans valeur.

D'autre part on a essayé dans le passé divers procédés pour obtenir des couches dont la couleur est très proche de celle de l'or, tout en présentant une dureté et une résistance à l'usure élevées. Ces essais ont surtout concerné des couches de nitrure de titane ou de métaux affins, tels que Zirconium et Hafnium, qui présentent une excellente dureté et une coloration jaune. Ces essais se sont toutefois heurtés à l'impossibilité d'obtenir une couche de nitrure de couleur équivalente à celle de l'or.

D'autres procédés connus portent sur la déposition de couches superposées de nitrure et de métaux fins, notamment la déposition d'un flash d'or d'environ 0,1-0,2 µm sur une sous-couche dure de nitrure de titane (TiN) d'environ 0,7-0,8 µm d'épaisseur. Ce type de revêtement souffre cependant d'un inconvénient majeur : l'usure progressive de la couche d'or révèle peu à peu la sous-couche de TiN, qui est plus foncée et plus brune, ce qui se traduit par un ternissement progressif de la couleur.

Les demandes de brevets EP411079 et EP258283 décrivent un procédé de dépôt d'une couche de fond d'un matériau tel que le ZrN ou le TiN, puis une seconde couche d'un métal fin tel que l'or. Cette méthode permet d'obtenir une couleur initialement équivalente à celle de l'or, mais la faible dureté de l'or et donc son usure rapide met rapidement à nu la couche de nitrure sous-jacente, modifiant ainsi la couleur à mesure que la couche superficielle s'use.

La demande de brevet EP4745035 porte sur un article dont le revêtement comprend deux couches superposées sur un substrat, la première étant un placage d'or pur, et la couche supérieure étant un mélange d'un nitrure métallique et d'or déposé par PVD ou CVD à partir de deux sources indépendantes ou d'une source composite. Ce procédé nécessite le dépôt d'une couche d'or relativement épaisse.

Le brevet US4415421 concerne un procédé de revêtement dont la première étape consiste à déposer un film de TiN, ZrN ou HfN suivi d'un film de transition comprenant du nitrure et de l'or, à partir de deux sources, en diminuant graduellement la quantité de nitrure afin d'obtenir une couche supérieure uniquement composée d'or. La couleur obtenue est donc déterminée par la couche supérieure d'or, et va se ternir à mesure que celle-ci s'use, exposant les couches plus riches en nitrure.

Les documents US6168242 et US20020172843 décrivent tous deux un article décoratif revêtu d'une pluralité de paires superposées de couches alternées de TiN/ZrN ainsi que son procédé d'obtention.

Le brevet JP60089565 concerne un procédé de revêtement dans lequel une première couche de base de nitrure ou de carbonitrure de titane est recouverte avec une couche d'environ 100 nm de nitrure ou de carbonitrure de zirconium.

### Divulgation de l'invention

Un but de la présente invention est de proposer un procédé de déposition d'une couche décorative exempt des limitations des procédés connus.

Un autre but de l'invention est de proposer un procédé de déposition d'une couche décorative qui ne prévoit pas l'emploi d'or, en quantité importante, ou qui ne prévoit pas du tout l'emploi d'or.

Un autre but de la présente invention est de proposer un procédé de déposition d'une couche décorative résistante à l'usure.

Un autre but de la présente invention est de proposer un procédé permettant d'obtenir des articles décoratifs dont la couleur est essentiellement équivalente à celle de l'or, et ne s'altère pas avec l'usure.

Ces buts sont atteints par le procédé et l'article qui sont l'objet des revendications indépendantes dans les catégories correspondantes, et notamment par un article décoratif ayant une surface comprenant une pluralité de paires superposées de couches alternées, chaque paire comprenant deux couches alternées de TiN et ZrN, avec le rapport entre le poids de Zr et la somme des poids de Zr et Ti dans le revêtement compris entre 50% et 80%.

### Brève description des dessins

La présente invention sera mieux comprise à la lecture de la description donnée à titre d'exemple et illustrée par les figures annexées dans lesquelles :
Les figures 1 et 2 montrent le comportement à l'usure d'un revêtement TiN/Au de type connu.
Les figures 3, 4, 5 représentent graphiquement la variation de couleur des couches de TiN, mesurée à l'aide d'un colorimètre, en fonction du flux d'azote.
La figure 6 représente schématiquement la structure d'un revêtement selon l'invention.
La figure 7 représente schématiquement un dispositif de dépôt selon l'invention.
Les figures 8 et 9 représentent des micrographies TEM d'un revêtement selon l'invention.
Les figures 10 et 11 représentent graphiquement la variation de couleur du revêtement de l'invention en fonction de la quantité d'azote.

### Mode(s) de réalisation de l'invention

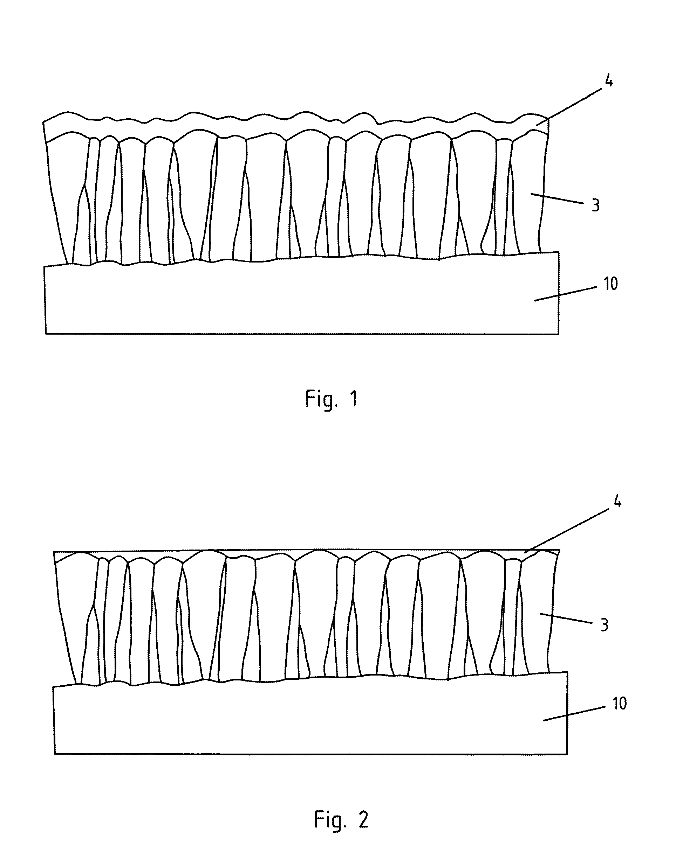

La figure 1 représente en section un article décoratif destiné à être porté, comme par exemple une boîte de montre, et donc sujet à usure. L'article comprend un substrat 10, par exemple en laiton nickelé ou en acier, sur lequel on a déposé une sous-couche de TiN ou de ZrN 3 d'environ 0,7-0,8 µm d'épaisseur et ensuite un flash d'or 4 d'environ 0,1-0,2 µm. La couleur de la surface est totalement déterminée par la couleur de la couche 4 et elle est identique à celle de l'or.

La figure 2 représente la même pièce après avoir été portée quelques mois, en conditions normales. On peut constater qu'en certains endroits la couche d'or 4 est totalement usée et la sous-couche 3 commence à apparaître. La couleur de la sous-couche 3 est plus rougeâtre que la couleur recherchée de l'or dans le cas du TiN, et plus verdâtre dans le cas du ZrN. En chaque cas la couleur recherchée de l'or commence à ternir déjà après quelques mois et on retrouve la couleur de la sous-couche 3 après environ 6 à 12 mois que la pièce a été portée.

La détermination quantitative de la couleur d'une surface est effectuée à l'aide des paramètres de l'espace de couleur standard CIE 1976 (L*, a*, b*) désigné standard CIELAB par la suite. Les paramètres L* a* b* du standard sont donnés dans ce document par rapport à une mesure selon le standard CIE 1964 (distance observateur - illuminant de 10 °) et une source d'éclairage standard CIE D65 (Lumière du jour 6500°K), sauf autre indication.

Le tableau 1 résume les paramètres L* a* b* pour les couleurs de l'or standard 1N14 et 2N18

**Tableau 1**

| | L* | a* | b* |
|---|---|---|---|
| Au1N14 | 86 | 3.8 | 23.8 |
| Au2N18 | 86 | 4.8 | 26.1 |

D'autres standards d'or, par exemple l'or 3N 18 sont également utilisés, et présentent des couleurs différentes.

Des couches de nitrures métalliques, par exemple TiN, HfN ou ZrN peuvent être obtenues par des techniques de dépôt physique en phase vapeur (PVD), par exemple par des méthodes de pulvérisation cathodique (Sputtering) à partir d'une source de l'élément métallique correspondant (titane, zirconium ou hafnium) en une atmosphère réactive contenant de l'azote. Des techniques d'alimentation de la cible en courant continu ou pulsé (DC-sputtering) ou en radiofréquence (RF-Sputtering) sont utilisables pour déposer ce type de couches.

Dans le cadre de l'invention, d'autres techniques PVD sont également possibles, comme par exemple la déposition par arc cathodique ou la déposition ionique, ou tout autre technique de dépôt.

Ces revêtements, et notamment le revêtement en TiN, sont caractérisés par une excellente dureté et ils sont utilisés pour cette raison comme couche anti-usure pour des outils de coupe.

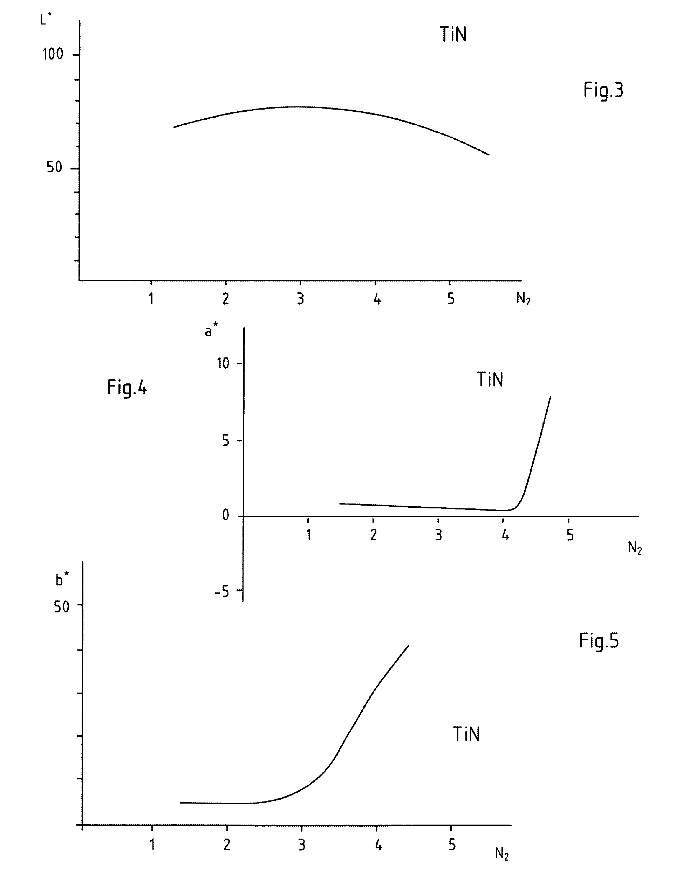

La couleur jaune des couches de nitrures peut varier selon les conditions de pulvérisation, et notamment en fonction de la pression partielle d'azote. Cependant, plusieurs essais on démontré l'impossibilité d'obtenir une couleur équivalente à celle de l'or, par exemple les couleurs des alliages standard 1 N et 2N. Les figures 3, 4 et 5 montrent la dépendance des paramètres L*, a*, b* en fonction du taux d'azote pour une installation particulière. Aucune concentration d'azote ne permet de s'approcher de la couleur recherchée. Notamment la clarté (paramètre L*) reste systématiquement inférieure aux valeurs des standards d'or. Lorsque le paramètre a* (vert à rouge) est optimisé, le paramètre b* (bleu à jaune) est trop élevé, conférant aux couches une couleur trop jaune et un éclat déjà diminué.

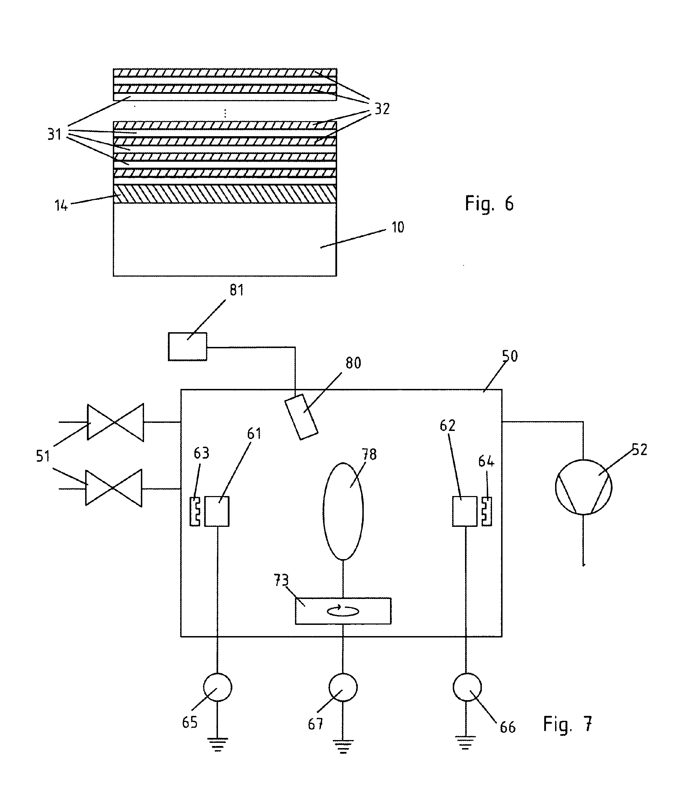

Une méthode de dépôt selon l'invention sera maintenant décrite en référence à la figure 7. Le dépôt a lieu à l'intérieur d'une enceinte 50 évacuée par un système de pompage 52. Le substrat 78, soit l'objet destiné à recevoir le dépôt décoratif, est placé sur un porte substrats tournant 73, de manière à présenter toutes ses surfaces à l'une et à l'autre des deux sources PVD 61 et 62, qui sont disposées en vis-à-vis, de part et d'autre du substrat 78.

Les sources de PVD 61 et 62 sont, dans cet exemple, deux sources de sputtering de Ti et de Zr. Deux sources d'alimentation 65 et 66 assurent la polarisation des sources 61 et 62. L'alimentation peut être soit en mode continu ou pulsé (DC-sputtering) soit en mode radiofréquence (RF-sputtering).

Des vannes de dosage 51, connectées à des réservoirs de gaz non représentés, permettent de maintenir à l'intérieur de la chambre à vide une atmosphère raréfiée de la composition chimique requise par le procédé de l'invention, par exemple une atmosphère réactive comprenant argon et azote, comme on verra plus loin.

Avantageusement on adoptera pour les sources 61 et 62 des sources de type magnetron, comprenant chacune un élément magnétique 63, respectivement 64, pour augmenter le rendement de pulvérisation. D'autres sources PVD pourraient aussi être employées, par exemple des sources à arc électrique, comme déjà évoqué.

Les surfaces de l'article 78, entraîné par le porte-substrats tournant 73 reçoivent alternativement les atomes et les ions éjectés par les sources 61 et 62, et se recouvrent ainsi d'une pluralité de couches superposées provenant des deux sources 61 et 62.

Une séquence de déposition selon l'invention est maintenant décrite avec référence aux figures 6 et 7. Le substrat 10 de l'article décoratif destiné à recevoir le revêtement est de préférence composé d'un matériau métallique facile à mettre en forme et à usiner, par exemple d'un alliage de cuivre tel que le laiton, ou d'un alliage ferreux. Le substrat pourrait aussi être constitué d'un autre alliage métallique, ou même d'un matériau synthétique moulé ou de céramique frittée ou de tout autre matériau.

Les articles usinés sont ensuite dégraissés chimiquement puis séchés par exemple à l'aide d'un système de nettoyage solvant / co-solvant, afin d'améliorer l'adhérence du revêtement déposé ultérieurement.

Les articles 78 sont introduits dans l'enceinte à vide 50 et placés sur le porte-substrats 73. Les articles 78 peuvent aussi être mus par un système de convoyage automatique ou manuel, permettant de traiter une grande quantité d'articles en un cycle de fabrication. Optionnellement le porte-substrats 73 peut aussi être amovible et les articles 78 peuvent être placé sur le porte-substrats 73 avant leur introduction dans l'enceinte 50.

Le dispositif de dépôt de l'invention peut aussi être arrangé de manière à accepter plus d'un substrat en même temps dans la région de dépôt, de manière à traiter en même temps plusieurs articles.

Les substrats 10 sont de préférence nettoyés avant toute utilisation au cours d'une opération de décapage ionique. Dans ce but, une tension continue négative ou radiofréquence est appliquée sur les substrats. Des cations d'argon dans l'enceinte 50 vont être accélérés par cette tension et projetés sur les substrats qui seront ainsi parfaitement nettoyés, permettant une meilleure adhérence des revêtements sur le substrat.

Cette étape de décapage ionique peut être effectuée dans la même enceinte de pulvérisation 50, ou dans une section préliminaire non représentée du dispositif de dépôt.

Une sous-couche d'accrochage 14, par exemple un revêtement à base de titane, est avantageusement déposé sur le substrat 10. Cette opération est optionnelle et n'est nécessaire que si le matériau du substrat ne permet pas une bonne adhérence des revêtements successifs. Dans ce but, le générateur 65 applique une tension continue négative ou radiofréquence sur la source 61 en titane tandis que le substrat 10 est maintenu à la masse ou polarisé négativement par le générateur 67. Un champ magnétique est de préférence appliqué par le magnétron 63 qui permet d'accroître et de mieux concentrer la pulvérisation en superposant un champ magnétique au champ électrique. Les ions de gaz, par exemple d'argon, sont accélérés vers la cible source 61 et la pulvérisent. Des atomes de titane sont ainsi éjectés de la source 61 en direction du substrat 10 où ils se condensent pour former un revêtement 14. Pendant cette phase l'article 78 est entraîné en rotation par le porte substrat 73 afin de revêtir toutes les surfaces de l'article 78 d'une sous-couche d'accrochage 14.

Ensuite, une tension continue négative ou radiofréquence est appliqué par le générateur 66 sur la source 62 en Zirconium tandis que une certaine quantité d'azote est mélangée à l'atmosphère d'argon par les vannes 51. En ces conditions une succession alternée de couches de TiN 31 et de ZrN 32 est déposée sur le substrat 10 de l'article 78.

L'épaisseur des couches individuelles de TiN 31 et de ZrN 32 est déterminée par la puissance électrique appliquée aux sources de sputtering 61 et 62, et par la vitesse de rotation du porte-substrats 73. D'autre part, le rapport R entre la puissance appliquée à la source de Ti et celle appliquée à la source de Zr permet de varier le rapport Ti :Zr du dépôt final.

Avantageusement, la vitesse de rotation du porte substrat 73 est adaptée de manière à produire des couches alternées 31, 32 dont l'épaisseur individuelle est inférieure à 50 nm, préférablement inférieure à 10 nm, plus préférablement de l'ordre de 1nm. De cette manière les couches de TiN et de ZrN contribuent ensemble à la couleur perceptible du dépôt décoratif. En revanche, dans le cas de couches plus épaisses que 100 nm, la couleur de la couche supérieure est prédominante et on obtient une couleur trop proche de celle du TiN, trop rouge (a* trop élevé) ou de celle du ZrN, trop verte (a* trop faible).

La couleur du revêtement décoratif de l'invention est aussi insensible à l'usure car, même si l'usure porte en surface des couches qui étaient précédemment couvertes, la couleur résultante est toujours le résultat de la contribution de plusieurs couches superposées.

Le titane et le zirconium présentant des réactivités assez comparables, il est possible d'obtenir des couches de TiN et ZrN pour la même valeur du flux d'azote. Optionnellement, il serait aussi possible d'installer une arrivée de gaz réactif indépendante pour chaque source.

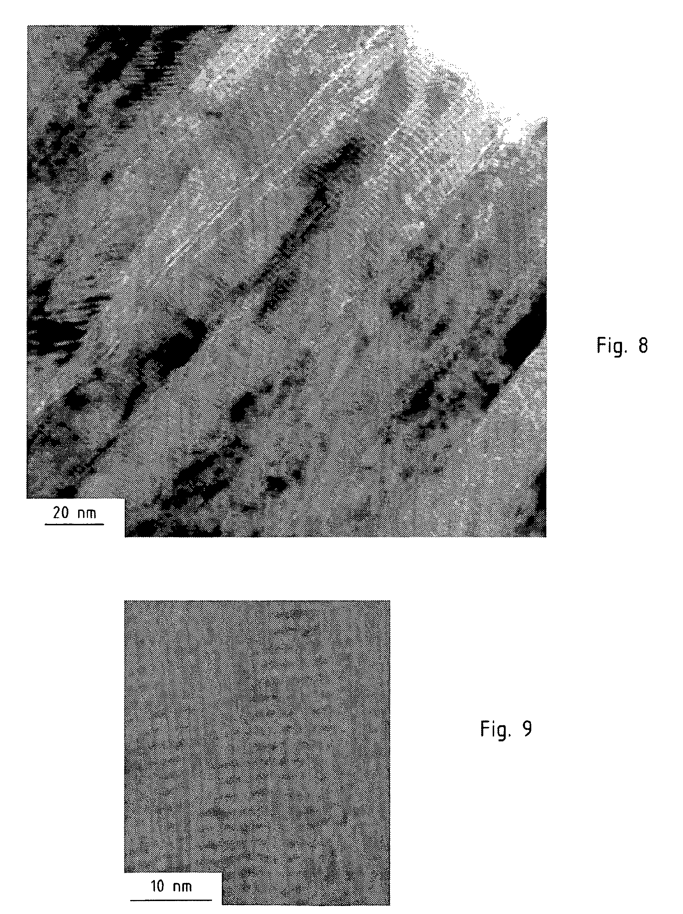

Les figures 8 et 9 représentent deux micrographies de la structure d'un revêtement selon la présente invention obtenue par un microscope électronique à transmission. Sur la figure 8, la structure colonnaire du TiN/ZrN est clairement visible. La figure 9, à fort grossissement, montre les couches individuelles d'une épaisseur de environ 1 nm. Les couches alternées de TiN et ZrN forment un superréseau cohérent.

L'épaisseur des couches individuelles peut aussi être évaluée de façon indirecte à partir de l'épaisseur totale du revêtement et du nombre de tours effectué par le substrat. L'échantillon des figures 8 et 9 a été réalisé avec deux sources avec 480 tours du substrat pour une épaisseur totale de 1 µm, ce qui donne une épaisseur de couche individuelle de l'ordre du nanomètre. Les photographies 8 et 9 démontrent toutefois que la déposition a effectivement lieu couche par couche, sans diffusion appréciable à l'interface.

Le taux d'azote est adapté pour obtenir des couches essentiellement stoechiométriques de TiN, et ZrN, préférablement des couches légèrement appauvries en azote, étant donné qu'un taux élevé d'azote comporte une réduction du paramètre de couleur L* (éclat).

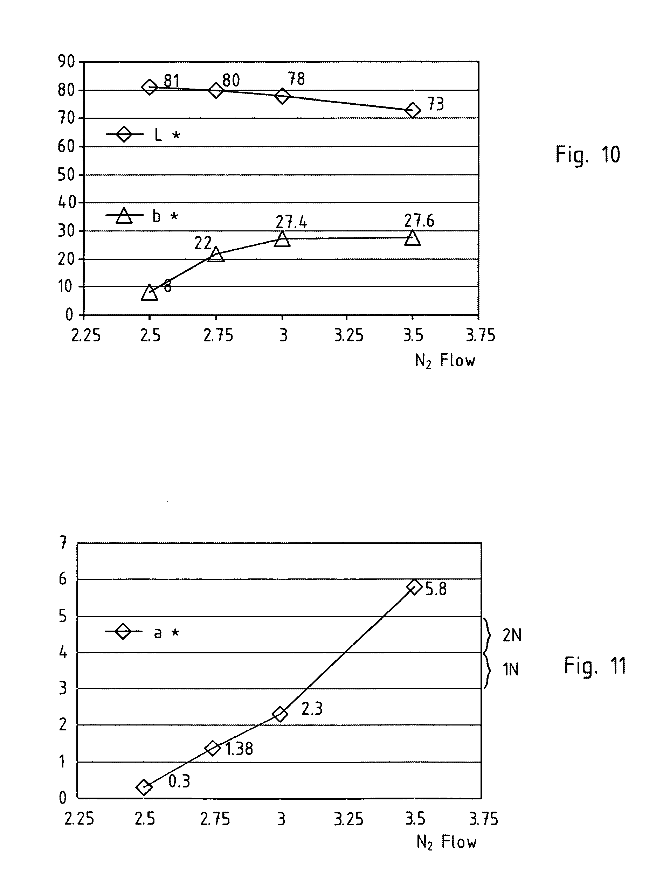

La figure 10 montre la dépendance des paramètres L* et b* en fonction du taux d'azote pour un revêtement multicouches selon la présente invention. L'éclat du revêtement baisse progressivement avec le flux de N₂ et la valeur de b* atteint une valeur stationnaire proche de 27 unités, ce qui est très proche du paramètre b* recherché pour l'or 2N.

La valeur de a* est également très sensible au taux de N₂, comme indiqué sur le graphique de la figure 11. Cependant ce paramètre est aussi très sensible au rapport Ti : Zr, qu'on peut contrôler en ajustant les puissances appliquées aux sources.

Avantageusement, un spectromètre optique 80 permet la surveillance en continu de la composition du revêtement déposé. L'unité de mesure et contrôle 81 modifie les paramètres de dépôt, et notamment le débit des vannes de réglage 51 durant la déposition, en fonction de la composition observée. Optionnellement, d'autres paramètres de dépôt peuvent aussi être réglés automatiquement durant la déposition, par exemple le potentiel électrique des sources 61 et 62 et du substrat 10.

Des analyses RBS (Rutherford Backscattering) ont permis de mesurer les compositions chimiques des couches individuelles 31 et 32, et notamment la proportion entre le poids de Zr et la somme Zr + Ti, en poids.

Les meilleurs résultats ont été obtenus pour des revêtements dans lesquels le rapport entre Zr /(Zr+Ti), en poids, varie entre 50% et 80% préférablement entre 65% et 80%, plus préférablement entre 70% et 75%. Les paramètres chimiques et de couleur d'un revêtement selon la présente invention sont résumés dans le tableau 2.

**Tableau 2**

| | Ti (poids) | Zr (poids) | L* | a* | b* | Nanodureté (Vickers) |
|---|---|---|---|---|---|---|
| | | | (angle observateur 10°) | | | |
| Au1N14 | - | - | 86 | 3.8 | 23.8 | ca 200 |
| Au2N18 | - | - | 86 | 4.8 | 26.1 | ca 200 |
| TiN/ZrN | 26% | 74% | 74.5 | 4.8 | 27.3 | > 3000 |

Les conditions de déposition de ce revêtement ont été optimisées dans le but d'obtenir une imitation la plus fidèle possible de la couleur de l'or, et notamment des standards 2N18, 1N14 et 3N18. Par exemple la couleur 2N18 est obtenue par un rapport, en poids entre Zr et Ti proche de 75% /25%, pour cette installation de déposition.

Le paramètre L * peut être augmenté par un bombardement ionique plus intense, par exemple avec des magnetrons déséquilibrés en géométrie opposée.

L'invention permet aussi d'obtenir des revêtements de couleurs différentes, par exemple en choisissant un rapport entre Zr et Ti différent. Il est aussi possible de remplacer l'une des sources de Titane et de Zirconium par une source d'Hafnium, pour obtenir des nuances de jaune qui ne seraient pas atteignables en mélangeant TiN et ZrN, ou ajouter une source de Hf pour obtenir des superréseaux TiN:ZrN:HfN. Des couches de métaux fins, par exemple d'or ou d'un autre métal pourraient aussi être superposées aux couches de nitrures ou interposées entre celles-ci.

Les revêtements TiN:ZrN de l'invention présentent une bonne adhérence aux substrats communément utilisés pour la production d'articles décoratifs, par exemple au laiton et à l'acier inox. Les revêtements de la présente invention ont une dureté extrêmement élevée, et présentent une très grande résistance à l'usure.

## Revendications

1. Article décoratif, ayant une surface couverte par un revêtement, le revêtement comprenant une pluralité de paires superposées de couches alternées, chaque paire comprenant deux couches alternées de TiN et de ZrN, pour donner au dit revêtement une couleur prédéterminée, **caractérisé en ce que** le rapport entre le poids de Zr et la somme des poids de Zr et Ti dans le revêtement est compris entre 50% et 80%.

2. Article décoratif selon la revendication précédente, dans lequel ledit rapport entre le poids de Zr et la somme des poids de Zr et Ti, dans lesdites couches superposées, est de 75%.

3. Article décoratif selon l'une des revendications précédentes, dans lequel le revêtement ne comprend pas de couches d'or ou de couches d'un matériau contenant de l'or.

4. Article décoratif selon l'une des revendications précédentes, dans lequel lesdites couches ont une épaisseur individuelle inférieure à 100 nm.

5. Article décoratif selon l'une des revendications précédentes, dans lequel lesdites couches ont une épaisseur individuelle inférieure à 10 nm.

6. Article décoratif selon l'une des revendications précédentes, dans lequel lesdites couches ont une épaisseur individuelle égale à 1 nm.

7. Article décoratif selon l'une des revendications précédentes, dans lequel lesdites couches forment un superréseau.

8. Article décoratif selon l'une des revendications précédentes dans lequel lesdites couches confèrent à la dite surface une couleur équivalente à celle de l'or 2N 18 ou 1 N 14 ou 3N 18.

9. Article décoratif selon l'une des revendications précédentes dans lequel le paramètre de couleur L* selon le standard CIELAB de ladite surface est égale ou supérieur à 70; le paramètre de couleur a* selon le standard CIELAB est compris entre 3.5 et 5 et le paramètre de couleur b* selon le standard CIELAB est compris entre 23 et 30.

10. Article décoratif selon l'une des revendications précédentes dans lequel lesdites couches sont obtenues par déposition à partir de plusieurs sources comprenant respectivement du Ti et du Zr.

11. Procédé de déposition d'une couche décorative sur un article ayant une surface, comprenant les étapes de :
déposer une première couche d'un nitrure d'un métal choisi parmi Ti et Zr;
déposer une seconde couche d'un nitrure d'un métal choisi parmi Ti et Zr, différent du métal constituant ladite première couche, superposée à la dite première couche ;
répéter les deux étapes précédentes pour obtenir un ' revêtement comprenant une pluralité de paires superposées de couches alternées de composition chimique TiN et ZrN
**caractérisé en ce que** les vitesses de déposition de TiN et ZrN sont choisies de manière à que le rapport entre le poids de Zr et la somme des poids de Zr et Ti dans le revêtement soit compris entre 50% et 80%.

12. Procédé selon la revendication 11, dans lequel lesdites couches confèrent à la dite surface une couleur prédéterminée.

13. Procédé selon l'une des revendications de 11 à 12, dans lequel lesdites couches ont une épaisseur individuelle inférieure à 100 nm.

14. Procédé selon la revendication 11, dans lequel lesdites couches ont une épaisseur individuelle inférieure à 10 nm.

15. Procédé selon la revendication 11, dans lequel lesdites couches forment un superréseau.

16. Procédé selon l'une des revendications de 11 à 15 dans lequel lesdites couches confèrent à la dite surface une couleur équivalente à celle de l'or 2N18 ou 1N14 ou 3N18.

17. Procédé selon l'une des revendications de 11 à 15 dans lequel le paramètre de couleur L* selon le standard CIELAB de ladite surface est égale ou supérieur à 70 ; le paramètre de couleur a* selon le standard CIELAB est compris entre 3.5 et 5 et le paramètre de couleur b* selon le standard CIELAB est compris entre 23 et 30.

18. Procédé selon l'une des revendications de 11 à 17 dans lequel lesdites couches sont déposées par plusieurs sources comprenant respectivement du Ti et du Zr.

19. Procédé selon l'une des revendications de 11 à 18 dans lequel lesdites sources sont des sources de sputtering.

20. Procédé selon l'une des revendications de 11 à 18 dans lequel lesdits articles sont disposés sur un support tournant de manière à recevoir les atomes et les ions émis par lesdites sources de manière alternée.

21. Procédé selon la revendication 18, comprenant une étape de :
modifier la composition de l'atmosphère de déposition en fonction de la couleur de surface recherchée.

22. Procédé selon la revendication 18, comprenant une étape de :
modifier la puissance appliquée auxdites sources en fonction de la couleur de surface recherchée.

23. Procédé selon l'une des revendications 21 ou 22, comprenant des étapes de :
mesurer la couleur de surface du revêtement et de modifier la composition de ladite atmosphère et/ou la puissance appliquée auxdites sources en fonction d'un écart entre la couleur de surface mesurée et la couleur de surface souhaitée.

## Claims

1. Decorative article having a surface covered by a coating, the coating comprising a plurality of superimposed pairs of alternating layers, each pair having two alternating layers of TiN and of ZrN, to give said coating a predetermined colour, **characterized in that** the ratio of the weight of Zr to the sum of the weights of Zr and Ti in the coating is comprised between 50% and 80%.

2. Decorative article according to the preceding claim, wherein said ratio of the weight of Zr to the sum of the weights of Zr and Ti, in said superimposed layers, is 75%.

3. Decorative article according to one of the preceding claims, wherein the coating does not comprise any layers of gold or any layers of a material containing gold.

4. Decorative article according to one of the preceding claims, wherein said layers have an individual thickness less than 100 nm.

5. Decorative article according to one of the preceding claims, wherein said layers have an individual thickness less than 10 nm.

6. Decorative article according to one of the preceding claims, wherein said layers have an individual thickness equal to 1 nm.

7. Decorative article according to one of the preceding claims, wherein said layers form a super-network.

8. Decorative article according to one of the preceding claims, wherein said layers give said surface a colour equivalent to that of gold 2N18 or 1 N14 or 3N18.

9. Decorative article according to one of the preceding claims, wherein said colour parameter L* according to the CIELAB standard of said surface is equal to or greater than 70; the colour parameter a* according to the CIELAB standard is comprised between 3.5 and 5 and the colour parameter b* according to the CIELAB standard is comprised between 23 and 30.

10. Decorative article according to one of the preceding claims, wherein said layers are obtained by deposition from several sources comprising Ti and Zr respectively.

11. Method for depositing a decorative layer on an article having a surface, comprising the steps of:
depositing a first nitride layer of a metal chosen from among Ti and Zr;
depositing a second nitride layer of a metal chosen from among Ti and Zr, different from the metal constituting said first layer, superimposed to said first layer;
repeating the two preceding steps to obtain a coating comprising a plurality of superimposed pairs of alternating layers of TiN and ZrN chemical composition,
**characterized in that** the speeds of deposition of TiN and ZrN are chosen so that the ratio of the weight of Zr to the sum of the weights of Zr and Ti in the coating is comprised between 50% and 80%.

12. Method according to claim 11, wherein said layers give said surface a predetermined colour.

13. Method according to one of the claims 11 to 12, wherein said layers have an individual thickness less than 100 nm.

14. Method according to claim 11, wherein said layers have an individual thickness less than 10 nm.

15. Method according to claim 11, wherein said layers form a super-network.

16. Method according to one of the claims 11 to 15, wherein said layers give said surface a colour equivalent to that of gold 2N18 or 1 N14 or 3N18.

17. Method according to one of the claims 11 to 15, wherein said colour parameter L* according to the CIELAB standard of said surface is equal to or greater than 70; the colour parameter a* according to the CIELAB standard is comprised between 3.5 and 5 and the colour parameter b* according to the CIELAB standard is comprised between 23 and 30.

18. Method according to one of the claims 11 to 17, wherein said layers are deposited from several sources comprising Ti and Zr respectively.

19. Method according to one of the claims 11 to 18, wherein said sources are sputtering sources.

20. Method according to one of the claims 11 to 18, wherein said articles are placed on a support rotating so as to receive the atoms and ions emitted by said sources in an alternating manner.

21. Method according to claim 18, comprising a step of:
modifying the composition of the deposition atmosphere according to the desired surface colour.

22. Method according to claim 18, comprising a step of:
modifying the power applied to said sources according to the desired surface colour.

23. Method according to one of the claims 21 or 22, comprising the steps of:
measuring the coating's surface colour and modifying the composition of said atmosphere and/or the power applied to said sources according to the divergence between the measured surface colour and the desired surface colour.

## Patentansprüche

1. Dekorativer Gegenstand mit einer durch eine Beschichtung bedeckten Oberfläche, wobei die Beschichtung eine Vielzahl von übereinanderliegenden Paaren von abwechselnden Schichten umfasst, wobei jedes Paar zwei abwechselnde Schichten TiN und ZrN umfasst, um der besagten Beschichtung eine vorbestimmte Farbe zu verleihen, **dadurch gekennzeichnet, dass** das Verhältnis zwischen dem Gewicht von Zr und der Summe der Gewichte von Zr und Ti in der Beschichtung zwischen 50% und 80% liegt.

2. Dekorativer Gegenstand gemäss dem vorhergehenden Anspruch, worin das besagte Verhältnis zwischen dem Gewicht von Zr und der Summe der Gewichte von Zr und Ti, in den besagten übereinanderliegenden Schichten, 75% ist.

3. Dekorativer Gegenstand gemäss einem der vorhergehenden Ansprüche, worin die Beschichtung keine Goldschichten oder keine Schichten aus einem goldhaltigen Material umfasst.

4. Dekorativer Gegenstand gemäss einem der vorhergehenden Ansprüche, worin die besagten Schichten eine Dicke von jeweils weniger als 100 nm aufweisen.

5. Dekorativer Gegenstand gemäss einem der vorhergehenden Ansprüche, worin die besagten Schichten eine Dicke von jeweils weniger als 10 nm aufweisen.

6. Dekorativer Gegenstand gemäss einem der vorhergehenden Ansprüche, worin die besagten Schichten eine Dicke von jeweils weniger als 1 nm aufweisen.

7. Dekorativer Gegenstand gemäss einem der vorhergehenden Ansprüche, worin die besagten Schichten ein Supernetzwerk bilden.

8. Dekorativer Gegenstand gemäss einem der vorhergehenden Ansprüche, worin die besagten Schichten der besagten Oberfläche eine Farbe entsprechend derjenigen von Gold 2N18 oder 1 N 14 oder 3N18 ' verleihen.

9. Dekorativer Gegenstand gemäss einem der vorhergehenden Ansprüche, worin der Farbparameter L* gemäss dem CIELAB-Standard der besagten Oberfläche gleich wie oder grösser als 70 ist; der Farbparameter a^{*} gemäss dem CIELAB-Standard zwischen 3.5 und 5 liegt und der Farbparameter b^{*} gemäss dem CIELAB-Standard zwischen 23 und 30 liegt.

10. Dekorativer Gegenstand gemäss einem der vorhergehenden Ansprüche, worin die besagten Schichten durch Abscheidung von mehreren Ti- bzw. Zr-haltigen Quellen erzielt werden.

11. Verfahren zur Abscheidung einer dekorativen Schicht auf einem Gegenstand mit einer Oberfläche, mit den folgenden Schritten:
Abscheidung einer ersten Nitridschicht eines unter Ti und Zr gewählten Metalls;
Abscheidung einer zweiten Nitridschicht eines unter Ti und Zr gewählten Metalls, welches anders als das die besagte erste Schicht bildende Metall ist, über die erste Schicht liegend;
Wiederholung der beiden vorhergehenden Schritte, um eine Beschichtung zu erzielen, welche eine Vielzahl von übereinanderliegenden Paaren von abwechselnden Schichten mit einer TiN und ZrN chemischen Zusammensetzung umfasst,
**dadurch gekennzeichnet, dass** die Abscheidungsgeschwindigkeiten von TiN und ZrN so gewählt werden, dass das Verhältnis zwischen dem Gewicht von Zr und der Summe der Gewichte von Zr und Ti in der Beschichtung zwischen 50% und 80% liegt.

12. Verfahren gemäss Anspruch 11, worin die besagten Schichten der besagten Oberfläche eine vorbestimmte Farbe verleihen.

13. Verfahren gemäss einem der Ansprüche 11 bis 12, worin die besagten Schichten eine Dicke von jeweils weniger als 100 nm aufweisen.

14. Verfahren gemäss Anspruch 11, worin die besagten Schichten eine Dicke von jeweils weniger als 10 nm aufweisen.

15. Verfahren gemäss Anspruch 11, worin die besagten Schichten ein Supernetzwerk bilden.

16. Verfahren gemäss einem der Ansprüche 11 bis 15, worin die besagten Schichten der besagten Oberfläche eine Farbe entsprechend derjenigen von Gold 2N18 oder 1N14 oder 3N18 verleihen.

17. Verfahren gemäss einem der Ansprüche 11 bis 15, worin der Farbparameter L* gemäss dem CIELAB-Standard der besagten Oberfläche gleich wie oder grösser als 70 ist; der Farbparameter a* gemäss dem CIELAB-Standard zwischen 3.5 und 5 liegt und der Farbparameter b* gemäss dem CIELAB-Standard zwischen 23 und 30 liegt.

18. Verfahren gemäss einem der Ansprüche 11 bis 17, worin die besagten Schichten durch Abscheidung von mehreren Ti- bzw. Zr-haltigen Quellen erzielt werden.

19. Verfahren gemäss einem der Ansprüche 11 bis 18, worin die besagten Quellen Zerstäubungsquellen sind.

20. Verfahren gemäss einem der Ansprüche 11 bis 18, worin die besagten Gegenstände auf einem drehenden Träger angeordnet werden, um die durch die besagten Quellen emittierten Atome und Ionen auf abwechselnde Weise zu empfangen.

21. Verfahren gemäss Anspruch 18, mit dem folgenden Schritt:
Änderung der Zusammensetzung der Abscheidungsatmosphäre je nach angestrebter Oberflächenfarbe.

22. Verfahren gemäss Anspruch 18, mit dem folgenden Schritt:
Änderung der auf die besagten Quellen angewandten Leistung je nach angestrebter Oberflächenfarbe.

23. Verfahren gemäss einem der Ansprüche 21 oder 22, mit den folgenden Schritten:
Messung der Oberflächenfarbe der Beschichtung und Änderung der Zusammensetzung der besagten Atmosphäre und/oder der auf die besagten Quellen angewandten Leistung je nach Abweichung zwischen der gemessenen Oberflächenfarbe und der gewünschten Oberflächenfarbe.
